# EUROPEAN PATENT SPECIFICATION

(11) **EP 4 433 871 B1**
(45) Date of publication and mention of the grant of the patent: **25.03.2026**
(21) Application number: 22814449.9
(22) Date of filing: 14.11.2022
(51) Int. Cl.: G03F 7/00

(54) **MULTI-TEXTURED STAMP**
MEHRFACHTEXTURIERTER STEMPEL
TAMPON MULTI-TEXTURÉ

(30) Priority: 15.11.2021 EP 21208278
(43) Date of publication of application: 25.09.2024
(73) Proprietor: Morphotonics Holding B.V., 5503 LM Veldhoven (NL)
(72) Inventor: TER MEULEN, Jan Matthijs, 5503 LM Veldhoven (NL); TITULAER, Bram Johannes, 5503 LM Veldhoven (NL); VELDHUIZEN, Leon Willem, 5503 LM Veldhoven (NL)
(74) Representative: Patentwerk B.V.
(86) International application number: PCT/EP2022/081808
(87) International publication number: WO 2023/084082

(56) References cited:
- EP-A1- 3 312 675
- WO-A1-2015/163129
- WO-A1-2018/011208
- WO-A1-2021/094375
- US-A1- 2013 214 452

## Description

The application pertains to a flexible stamp and a method for making thereof.

The use of functional textured layers (the term "textured" encompasses e.g., pyramids, lenses, prisms, cones, flat layers) on devices is an important topic. The smart usage of such layers can enhance performance, reduce cost or improve the visual appearance of the product. For example, diffusing layers are used in displays, enabling the use of thinner LED backlight concepts and illuminating the display from the sides. Other new high-tech possibilities are the integration of functional textured layers into solar panels improving their efficiency or integration in organic light-emitting diode (OLED) lighting panels to extract more light.

Functional textured layers can be made by use of UV imprinting. In this case the substrate, or stamp, or both are coated with a lacquer (resin or resist). After pressing the stamp on the substrate with lacquer in between, the textured lacquer is cured to a solid phase. The curing method can be thermal or by use of UV light. Already in 1978, this technology was mentioned in US Patent 4,128,369. Further pioneering work was done by Chou in 1995. He demonstrated that by use of a rigid stamp sub-25 nm textures could be replicated at high throughput for mass production (US Patent 5,772,905 or in an article by Stephen Y. Chou, Peter R. Krauss, Preston J. Renstrom (Appl. Phys. Lett. 67 (1995) 3114-3116)). Later-on the use of a roller to apply pressure on either a rigid stamp or a bended thin metal sheet to replicate textures was demonstrated (article Hua Tan, Andrew Gilbertson, Stephen Y. Chou, J. Vac. Sci. Technol., B 16 (1998) 3926-3928).

Many institutes and companies continued this work, resulting in different techniques. In the semiconductor industry plate-to-plate imprinting is applied by using a rigid stamp in combination with a transfer process, materials and precise positioning as described in US Patent 6,334,960, US Patent Application 2004/0065976 and US Patent 8,432,548. The roll-to-roll imprinting technique uses textured rollers in combination with flexible substrates to texture foils or films in a continuous process as described in e.g. the US Patent 8,027,086.

The above-mentioned plate-to-plate technique is designed for the precise, wafer-scale, imprinting of small textures (feature size of sub-100nm) on uniform flat wafers with high position accuracy. But as described in the Chinese Patent Application CN 103235483, this technology is difficult to scale to a larger area.

By use of the roll-to-roll technology textured foils can be made continuously at high production speeds. These textured foils can be used as substrates for flexible applications or can be laminated onto rigid substrates. However, the latter comes at additional cost of an intermediate adhesive layer to adhere the textured flexible foil to the rigid substrate or product. Therefore, a third new technology is being developed: direct roll-to-plate imprinting. Hereby the functional textured layer is directly applied on the discrete substrate without the use of an auxiliary film that has an additional intermediate adhesive layer of tens to hundreds of microns thickness. In contrast to the plate-to-plate technology the imprint is made by use of rollers which are textured or by use of textured foils, also called flexible stamps, wound around rollers.

Roll-to-plate imprint has thus established as a standard technique for direct texturing of large rigid substrates while plate-to-plate imprinting has become standard for direct texturing of small rigid substrates.

Recent developments have also extended roll-to-plate imprinting of small periodic structures to large substrates by use of small flexible stamps which are repeatedly rolled over a large substrate as shown in EP 2 823 356 B1 or in WO 2021/094375 A1.

All these developments show that roll-to-plate imprinting is developing to an imprinting technique for large substrates while small substrates are typically textured by plate-to-plate imprinting.

However, plate-to-plate imprinting of small substrates is challenging because normally each substrate has a different height. These differences can be small, typically in the order of a few or 10's of microns. Still a small height step at the sharp edges of the substrates can damage the flexible stamp in the roll-to-plate imprint process with a pressure applied on the flexible stamp.

The textured area, consisting of very sensitive polymers, can suffer from severe damage when contacted with edges of the substrates, when several substrates are imprinted with one flexible stamp while during imprinting of a single substrate the edges of the substrate may be located such that they do not contact the textured area. The damage of the textured area can result in scratches, loose particles and yield loss, which should be prevented.

It is the object of the application to provide a fast and efficient technique for roll-to-plate imprinting of several smaller substrates at one time without damaging any parts of the flexible stamp.

The object is solved by a flexible stamp for use in an imprinting process comprising a carrier, the carrier comprising a first surface and at least two spots of a flexible material which spots are adhered to the first surface of the carrier and have a surface which is parallel to the front surface of the carrier and is textured with an imprinting pattern.

In one embodiment, adherence may also encompass embossing the carrier with the flexible material.

Throughout the application, the term "flexible" means that a material or a member thereof has a Young's modulus between 0.1 Giga Pascal (GPa) and 10 Giga Pascal (GPa). In an embodiment, the Young's modulus is between 0.5 Giga Pascal (GPa) and 5 Giga Pascal (GPa). The Young's Modulus is measured according to ASTM E111.

Throughout the application, the term "parallel" with reference to two surfaces, planes or areas means that said two surfaces, planes or areas either do not cross or cross forming a maximum angle of 6° with each other.

A stamp according to the application is any means that can be used for texturing, imprinting or embossing a surface. Typically, a stamp comprises an imprinting surface which is textured with an imprinting pattern of depressions and elevations which imprinting pattern is then transferred to a substrate. Said transfer may occur in three different manners. First, the imprinting surface may be treated with an imprinting material such as an ink, a color, or a resin in such a way that only elevations pick up the imprinting material and transfer it to the substrate following the principle of so-called relief imprinting which is also used e.g. by office stamps, classical typewriters or in historical book printing with lead types. In all these imprinting processes, only the elevations of the imprinting surface transfer imprinting medium to the substrate. Second, the imprinting surface may be covered with imprinting material such as an ink, a color or a resin in such a way that the depressions of the imprinting surface are filled up by the imprinting material. Afterwards, the imprinting surface may be wiped using e.g a doctor blade in such a way that the imprinting medium remains only in the depressions from which it is transferred to the substrate. If the substrate is paper, this imprinting technique is known as intaglio imprinting. Alternatively, the stamp may be used to texture a spot or layer of liquid or viscous imprintable medium such as resin, lacquer or wax in such a way that the depressions in the imprinting pattern become elevations on the substrate and elevations in the imprinting pattern become depressions on the substrate. This is comparable with the use of a traditional engraved seal matrix on sealing wax or sealing lacquer.

Third, the stamp may be pressed against a solid but formable surface and emboss a pattern therein similar to an embossed seal on paper.

The flexible stamp according to the application may be used in all said imprinting techniques.

The carrier according to the application forms kind of the backbone of the flexible stamp and may be of any flexible material. In an embodiment, the carrier is a plastic foil of e.g. polyethylene terephthalate or another flexible but robust polymeric material. The carrier can also be a thin sheet, e.g. a glass sheets, metal sheets. The carrier may also be of a composite material wherein e.g. thin glass, metal or polymer sheets are embedded onto or in between polymeric material.

In another embodiment the carrier is a combination of the plastic foil or thin sheet or embedded sheets with on top an adhesive layer, amongst others this can be a polymeric layer or pressure sensitive adhesive.

In an embodiment, the carrier may be transparent for visible and/or UV light in order to allow for a radiation-induced curing of a resin through the carrier.

In an embodiment, the carrier may comprise a UV protection agent in order to prevent degradation during radiation-induced curing. Possible UV protection agents may be from the group of Hindered Amine Light Stabilizers (HALS).

In an embodiment, the carrier may be heat resistant in such a way that it will not undergo any damages or loses its mechanical stability at typical curing temperatures of curable resin.

The carrier comprises a first surface and a second surface. More for the sake of definition the first surface is considered to be the surface which is faced towards the substrate during the imprinting process.

The flexible stamp further comprises at least two spots of a flexible polymeric material which are adhered to the first surface of the carrier. The adhesive connection between the spots and the carrier may be carried out by an additional adhesive material located in between the spots of flexible polymeric material and the first surface of the carrier or by an intrinsic adhesive connection between the polymeric material of the spots and the material of the carrier. The spots may also comprise several layers wherein the layer which faces away from the first surface of the carrier is textured with an imprinting pattern.

A spot according to the application is an area on the carrier which area is substantially smaller than the carrier and is characterized by the fact that it is usually made of a different material than the carrier and that this spot forms a distinct layer on the carrier. The spots according to the application may thus be interpreted as regions on the carrier which are smaller than the carrier and which form a second layer on the carrier. The spots on the carrier may also have the form of a coating. The spots may also be textured pieces of foil, e.g. plastic or glass or thin metal sheets, which are adhesively connected to the carrier in the manner of textured labels, with a polymeric layer on top.

The spots may be of any flexible polymeric material such as polymeric materials based on acrylates, methacrylates, fluorinated acrylates, epoxides, thiols, vinyl group containing monomers, ethers, fluorinated ethers, siloxanes, siloxane-acrylates, or blends of two or more of these materials.

In an embodiment, the flexible polymeric material is selected from a polymer type such as epoxides, thiols, polyvinyl resins, polyethers, fluorinated acrylates, fluorinated methacrylates, fluorinated polyethers, siloxanes, siloxane-acrylates, or blends thereof.

In an embodiment, the material of the spots may be the product of a consolidation or curing process of a material which has been brought in contact with the carrier in a liquid or viscous form and which has then been consolidated or cured while being in contact with the carrier. The material of the different spots can be the same or different.

The spots may have an additional intermediate base-layer, such as polycarbonate, PET, thin glass sheets, or thin metal sheets. In this case, the combined spots and base layers are adhered to the material of the carrier with an adhesive layer. Every spot according to the application has a planar surface which surface is parallel to the first surface of the carrier. The planar surfaces of every spot on the carrier have the same height in such a way that the surfaces of the spots are part of one imaginary plane which is parallel to the plane of the first surface of the carrier. The surface of every spot is at least partially textured by an imprinting pattern which forms depressions and elevations in the surface of the spot. The depressions may or may not be configured in such a way that they reach through the whole spot onto the material of the carrier. The texture may not cover the whole planar surface of the spot. According to the invention, the spot size, in length and width is larger compared to the preferred textured area on the substrate.

The spots can overlap each other or the spots may be separated from each other. Separated according to the pending application means that a spot is completely surrounded by an area wherein the "naked" or uncovered material of the carrier is facing towards the substrate. Hence, spots which are separated from each other are kind of islands on the carrier.

The spots may either have a regular form such as round, oval, rectangular or polygonal or the form of the spots may be irregular. The imprinting pattern may have both a size and a form which deviates from the size and the form of the spot; however, the size of the spot will always be larger as the size of the imprinting pattern. In an embodiment, the imprinting pattern may be rectangular while the spot carrying the imprinting pattern may have a round, oval or irregular form.

The textures on the surfaces of the spots may be the same or different. The flexible stamp according to the application may have groups of adjacent spots with the same texture. Groups of adjacent spots with the same texture may form lines, columns, diagonal lines or any other kind of design on the carrier. The spots can also be placed randomly.

With multiple spots on the flexible stamp, according to the pending application, the flexible stamp may be used to texture more than one substrate at a time. This requires that more than one substrate is provided to the process according to the application in such a way that their surfaces are positioned directly underneath the textured surfaces of the spots. Using said procedure a large number of small substrates can be textured during one imprinting process. This is advantageous for substrates types that are only available in smaller sizes or saves the effort for cutting a large textured substrate apart which may cause damage or soiling on the textured surface. Using a flexible stamp according to the application can thus increase the throughput and, in addition, also the efficiency of imprinting processes for small substrates which are typically textured using plate-to-plate processes. The rigid stamps in plate-to-plate processes are much more difficult and expensive to replicate compared to a flexible stamp according to the application especially when the process is used which is presented later in this application.

The robust design of the flexible stamp does not limit the use of the flexible stamp to imprint substrates with similar size of one spot. In an embodiment, the flexible stamp can be used for imprinting substrates which cover more than one spot. The imprinting substrate can be of similar size as the flexible stamp. In such a case, the substrate is imprinted with several separate textures which may be the same, different or part of a periodic texture. Texturing is carried out by one passage of a large-scale substrate underneath the flexible stamp. The textured substrate may be further used as it is or may be separated into smaller pieces. This can be a manner for multiply replicating a small master onto a large substrate.

The robust design of the flexible stamp does not limit the use of the flexible stamp to imprint substrates which are smaller compared to the spot. This is still possible, but might have impact on yield.

The number of spots on the flexible stamp is not limited.

In the case of the use of an intermediate adhesive layer, the adhesive connection between the spots and the carrier may be either permanent or reversible. A reversible connection means that the spots may be removed from the carrier e.g. by use of a chemical agent such as a solvent, heating, mechanical stress or any combination thereof. Removal may be carried out in such a way that the carrier is not damaged. In an embodiment, the spots may completely be removed from the carrier and the carrier may be re-used by e.g. adhering new spots thereon.

In an embodiment, the polymeric material of the spots may have a surface free energy lower than 50 mN/m, in an embodiment, the surface free energy is lower than 35 mN/m, lower than 30 mN/m or even lower. In an embodiment, the polymeric material of the spots is chosen in such a way that it shows an adhesion that allows easy delamination from the cured resins which are typically used in imprinting processes using flexible stamps such as epoxides, thiols, polyvinyl resins, acrylates, methacrylates, polyethers, fluorinated acrylates, fluorinated methacrylates, fluorinated polyethers, siloxanes, siloxane-acrylates, or blends thereof.

The polymeric material of the spots may have anti-stick properties. If this is not the case, the flexible stamp may undergo an anti-stick treatment prior to use. Such surface treatment of the flexible stamp can be a plasma treatment, or an anti-stick coating treatment by a wet process, a vapor process, a gas phase process or a combination of these processes.

The carrier material in between the spots, not being covered by the spots, may have the same low surface free energy as the spots, for example it may have a surface free energy of 50 mN/m or lower to around 35 mN/m or even lower. The low surface energy can be characteristic for the carrier material, or it can be created on the carrier material by an additional surface treatment process. Such surface treatment of the carrier can be a plasma treatment, or an anti-stick coating treatment by a wet process, a vapor process, a gas phase process or a combination of these processes.

In another preferred embodiment, the carrier material in between the spots, not being covered by the spots, may have a hard-coat top surface, to protect the flex stamp from being damaged by the edges of several small substrates that are processed in a single imprinting step.

According to the invention, the surface of the spots is above the first surface of the carrier.

Such spots are kind of added to the carrier. In an embodiment, the top surface of the spots is higher above the first surface of the carrier than the depth of the deepest depression of the imprinting pattern. In another embodiment, the surface of the spots is higher above the first surface than the thickness variation of the layer of imprintable medium which is to be textured by the flexible stamp according to the application. Both these embodiments, which may also be combined, have the purpose of making sure that the material of the carrier does not get in contact with the imprintable medium.

In an embodiment, channels are formed between the spots on the carrier. Said channels may be interpreted as boundaries between the different spots and may furthermore have a function during the imprinting process which may be carried out using the flexible stamp according to the application. Through said channels either excess of imprintable medium or air which is entrapped in the system of the flexible stamp, the substrate and the imprintable medium may escape. The same effect as with the channels can be achieved by clearings between the different spots of material. In contrast to channels, clearings according to the present application are larger areas of empty space compared to channels. In contrast to channels, which are more line-shaped, clearings are more area-shaped. In general, both channels and clearings are areas of empty space where channels are more line-shaped while clearings are more space-shaped. Throughout the present application, the terms "channels" and "clearings" will be used synonymously, i.e. if not mentioned otherwise, both terms are meant if one of the terms is used.

The application further pertains to a process for making a flexible stamp according to claim 13. In one embodiment, the process further comprises the steps of providing at least one master, the at least one master comprising a textured area, providing a carrier with a width and length being same size or larger compared to the width and length of the textured area on the one or more masters, providing a curable resin to the master and/or on to the carrier, bringing the carrier and the master in contact with the resin in between , optionally exerting pressure to the carrier in such a way that the resin fills up the textured area and forms a layer covering the textured area, curing the resin while the resin is in contact with both the master and the carrier, separating the carrier with the cured resin from the master, moving the at least one master relative to the contact plane and in a plane parallel to the plane of the carrier or vice versa, with the steps bringing the carrier and master in contact with the resin , exerting pressure to the carrier, curing the resin and separating the carrier with the cured resin from the master being carried out at least twice.

The carrier according to the application forms kind of the backbone of the flexible stamp to be produced and may be of any flexible material. In an embodiment, the carrier is a plastic foil of e.g. polycarbonate or polyethylene terephthalate or another flexible but robust polymeric material. The carrier may also be of a composite material wherein e.g. thin glass sheets or thin metals sheets or thin are embedded into one or more polymeric materials.

In an embodiment, the carrier may be transparent for visible and/or UV light in order to allow for a radiation-induced curing of a resin through the carrier.

In an embodiment, the carrier may comprise a UV protection agent in order to prevent degradation during radiation-induced curing. Possible UV protection agents may be from the group of Hindered Amine Light Stabilizers (HALS).

In an embodiment, the carrier may be heat resistant in such a way that it will not undergo any damages or loses its mechanical stability at typical curing temperatures of curable resin.

The master is typically a rigid, planar plate of a durable material. In an embodiment, the master may be made of metals like steel, nickel, copper or aluminum. In an embodiment, the master may be of silicon, quartz or glass. In an embodiment, the master may be a plastic foil or plastic sheet. In an embodiment, the master is a silicon wafer. The master may have any form such as round, oval, rectangular, triangular, polygonic or irregular.

The master comprises a textured area. The textured area is an area on the surface of the master which comprises depressions and elevations forming a texture which may be regular, random or form any kind of drawing, picture or pattern. The textured area can be formed by engraving into the surface of the master by any engraving technique like milling. Other techniques are for instance, but not limited to; laser ablation, grey scale lithography, wafer-scale lithography and etching. The textured area has a surface area of at most half the surface area of the carrier. The textured area may have any form such as rectangular, triangular, polyconic, round, oval or irregular. The textured area may have a different form than the master. The textured area may be smaller than the master. It is thus possible to e.g. have a round master with a rectangular textured area inside.

The master may comprise detection markers. Detection markers according to the application are structures which are detected by e.g. a detection system comprising a camera and a computer which allow for a precise determination of the position and the orientation of the master. The detection markers may be specific patterns which may be engraved into the surface of the master or which may be drawn or painted on the master using e.g. a permanent ink. The detection markers may also be small pieces of a material which visually differs from the material of the master and which are adhered, welded or soldered to the master.

In order to allow for easy separation of the carrier with the cured resin from the master, the master may be treated with an anti-stick agent prior to being provided to the process for making a flexible stamp. Possible anti-stick agents may be low-viscosity silicone oils, paraffin oils, fatty oils, aliphatic surfactants, fluorinated surfactants, aliphatic siloxanes, fluorinated phosphonic acids, siloxanes or aliphatic or fluorinated silanes. For carrying out the process for making a flexible stamp properly, it is required that the anti-stick agent on the master and the curable resin do not mix with each other. The surface including the textured area of the master may have a surface free energy of at most 50 mN/m. In an embodiment, the surface free energy of the surface of the master including the textured area is at most 35 mN/m. In another embodiment, the surface free energy of the surface of the master including the textured area is at most 25 mN/m or at most 15 mN/m.

The curable resin may be provided to the master and/or on to the carrier by any possible dosing technique such as dip coating, dropping, slit coating, roll coating, waterfall coating, spray coating, vapor deposition, or inkjet printing. The curable resin may be provided directly to the master or the curable resin may be coated onto the carrier and then provided to the master when the carrier is brought in contact with the master. The curable resin may be dosed to either the master or the carrier in a controlled manner in order to avoid resin overflow on the one hand but to make sure that a layer of resin can be formed that covers the textured area. In an embodiment, the curable resin may be applied to the master as one or several droplets, puddles, lines, circles, ellipses, or any other geometric dispense pattern which are to be distributed after application. The one or several droplets may be positioned on the master and/or the carrier in such a way that upon exertion of pressure a layer is formed which covers the textured area of the master. The curable resin may be selected from a group consisting of epoxides, thiols, monomers for polyvinyl resins, acrylates, methacrylates, polyethers, fluorinated acrylates, fluorinated methacrylates, fluorinated polyethers, siloxanes, siloxane-acrylates or blends thereof.

The carrier is brought in contact with the resin on the master. In an embodiment, this step of the process is carried out in such a way that the carrier and the master do not get into direct contact but that the resin forms a layer which separates the carrier and the master from each other. By adjustment of the distance between the carrier and the master, the thickness of the resin layer between the carrier and the master can be adjusted and the distribution of the resin may be controlled. The smaller the distance between the master and the carrier is chosen, the thinner becomes the layer of resin. The resin may be chosen in such a way that after curing, the resin forms strong adhesive forces with the material of the carrier but, on the other hand, does not form adhesive forces with the surface of the master.

The carrier is brought in contact with the resin on the master in such a way that the resin fills up the textured area of the master and forms a layer covering the textured area. Depending on the viscosity of the resin, pressure exerted to the carrier and the resin may induce a resin flow over the master including the textured area which resin flow plays a key role in distributing the resin. Pressure may thus be exerted in a very well controlled manner in order to control the resin flow. Pressure may be exerted using e.g. a roller which is equipped with a means to exert pressure in a very well-controlled manner such as a linear motor or a hydraulic or pneumatic press.

The resin is cured while the resin is in contact with both the master and the carrier. Curing may be carried out in any manner known to the one skilled in the art such as thermal curing whereby the system of master, resin and carrier is heated to the curing temperature using e.g. an oven or heating by infrared radiation. Thermal curing is simplified if either the master or the carrier has high heat conductivity such as e.g. many metals have. Curing may also be carried out using visible or ultraviolet radiation emitted by a suitable lamp. Curing by visible or ultraviolet radiation is only possible if at least the master or the carrier is transparent for visible or ultraviolet radiation as it is the case e.g. for polymeric foils as carriers or quartz as material for the master. Curing while the master and the carrier are in contact with the resin assures that the resin is cured in a form which corresponds to the form of the textured area on the master.

After curing is completed, the carrier is separated from the master with the cured resin being adhered to the carrier forming a spot of cured resin on the carrier which spot may have at least the size of the textured area and at most the size of the master.

After separation of the carrier from the master, the master is moved relative to the carrier and in a plane parallel to the plane of the carrier. This movement may occur by moving the master e.g. on a stage or by keeping the master fixed on a stage or on a mount and moving the carrier. Movement will be carried out in such a way that the carrier is shifted at least by the extension of the textured area in the direction of shifting.

Movement of the master can be carried out e.g. using a robot such as a delta robot which places the master in position e.g. on a stage. The master may also be mounted in a mount which may be movable in at least one direction and may be positioned using e.g. stepper motors or servo motors. Movement of the master may be controlled by an optical detection device such as a camera coupled to a computer which may also be connected to the robot moving the master. The camera may follow the detection markers on the master in order to check whether the master is positioned and oriented properly.

Also, the position of the flexible stamp may be monitored using for instance an optical detection device. Hereby the position of the master can be placed in reference of the position of the flexible stamp.

After movement, the steps of providing the resin to the master, bringing the carrier in contact with the resin on the master and/or carrier, possibly exerting pressure, curing the resin and separating the carrier with the cured resin from the master are repeated such that a second spot is formed on the carrier after separating the carrier with the cured resin from the master again. In an embodiment, the second spot is separate from the first spot. Depending on the size of the master and the carrier and depending on the number of spots on the carrier which are necessary, the process can be repeated as often as necessary with the master being shifted at least by the extension of the textured area in the direction of shifting. Every execution of the process will lead to a new spot on the carrier and the process will thus lead to a flexible stamp with a manifold of spots with molded images of the textured area of the master.

In the case the polymeric material on the spots and/or the carrier do not have a surface free energy of below 50 mN/m an additional anti-stick treatment can be applied after the release of the carrier from the master having one or more spots. In the roll-to-plate process the carrier is brought in to contact with the master, with resin in between the master and carrier, by use of a roller. During the imprinting, using the roll-to-plate imprint process either the roller moves or the carrier and master, with resin in between the master and carrier moves, or both move in opposite directions. In order to ensure no friction hick ups in the movements between the moving roller and or moving carrier and master, with resin in between, it is proposed that the carrier and/or master movement is steered or the movement of the CenterPoint of the roller axis moves, but in both cases the roller is a free rotating roller. The rotation of the roller is not actively steered.

Further disclosed is an apparatus for making a flexible stamp, the apparatus comprising a stage to take at least one master, at least one roller, a flexible sheet of material, a means for curing a curable resin, a means for moving the master on the stage, a means for selectively dosing curable resin to the master and/or to the flexible sheet of material.

The flexible stamp can also be made in a cut and paste process. In this context, several available flexible stamps or masters are cut or machined to spots of a desired size, also called tiles, and these are grouped and pasted onto a carrier foil. The spots can already have anti-stick properties or the anti-stick properties can be added in a downstream anti-stick process.

In another downstream process the areas between the spots can be provided with additional materials. The material added in between the areas of the spots or tiles serves to protect the surface area at these positions from mechanical or other damage or contamination. This material can be comprised of an anti-stick material or by a hard-coat resin or lacquer. A possible method to add the materials can be any dispense process, for example a printing process.

### Figures

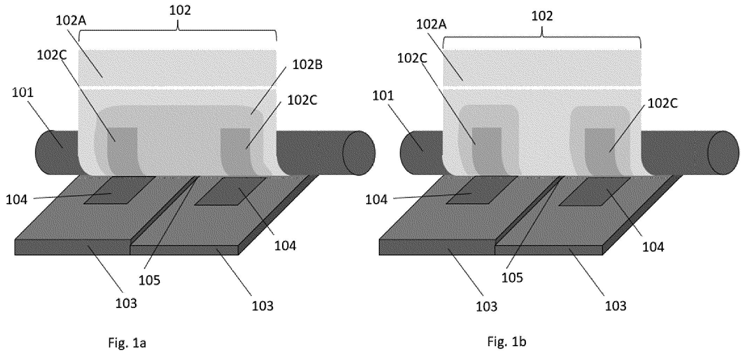

Figure 1a depicts the underlaying problem of a roll-to-plate imprint process whereby a flexible stamp 102 with carrier 102A and textured layer 102C in polymeric material 102B is brought in contact with the resin 104 on 2 different substrates 103 by use of roller 101. The substrates have a different substrate height, which results in a sharp contact at contact area 105 possibly damaging the fragile polymeric layer 102B. In Figure 1b this problem is solved having two separate spots of polymeric material 102B which do not touch the edge of the substrate.

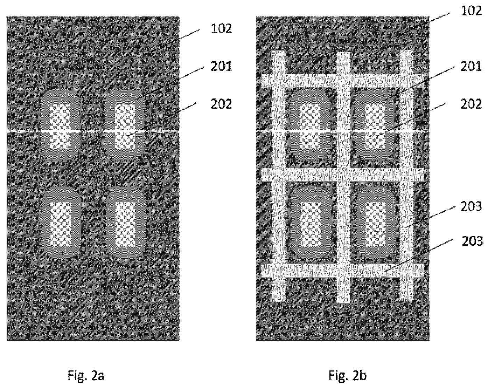

Figure 2 shows different flexible stamp designs, according to the proposed solution. In Fig. 2a a flexible stamp is shown with carrier 102 having 4 spots of polymeric material 201 each having a textured layer 202. This textured layer has the inverse of the preferred texture, also called active area, on the substrate. Fig. 2b shows a flexible stamp with carrier 102 having 4 spots of polymeric material 201 each with textured area 202. In between the spots of polymeric material 201 a process optimization material 203 is added. This can be a hard-coat material or a material with anti-stick properties.

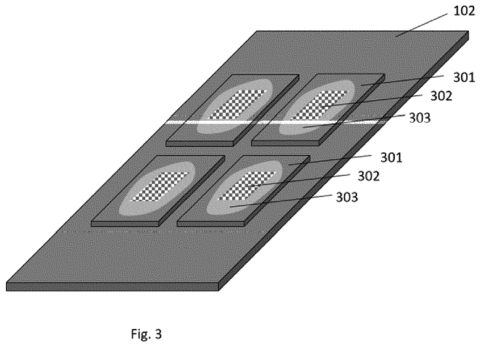

Figure 3 shows a flexible stamp design, according to the proposed solution consisting of a carrier 102 with 4 spots, each consisting of a foil 301 with a polymeric top layer 303. The polymeric layer 303 has a textured layer 302.

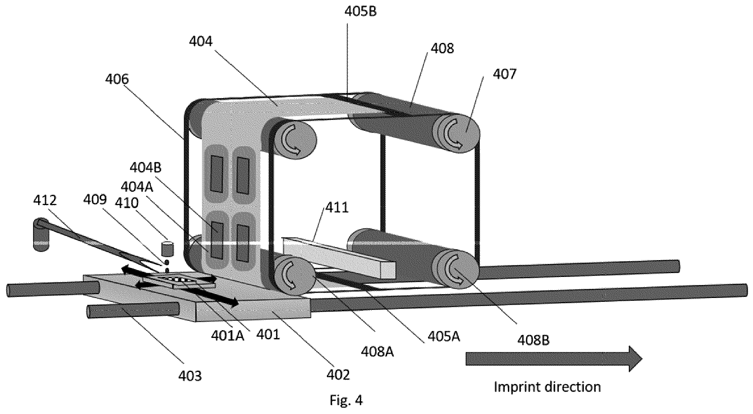

Figure 4 shows an apparatus, according to the proposed solution, to make a flexible stamp with multiple spots from a master. The master 401 with texture area 401A is placed on an imprint stage 402. This imprint stage 402 supports the master 401 in the imprint process and transports it through the apparatus by use of the gliders 403, whereby the imprint direction is indicated with the arrow. The position of the master 401 can be adjusted with robot 412. In this graph resin droplets 409 are printed on the master with dispense tool 410. The master 401 with resin 409 is brought into contact with the carrier 404, by use of the lamination roller 408A, creating the polymeric layer 404A with textured layer 404B. In this case carrier is hold by two clamps 405A and 405B mounted on two belts 406. The movement of the carrier is steered by the belt. In a next step the polymeric layer 404A is cured with UV light form the UV light source 411 and the carrier 404 with polymeric layer 404A and textured layer 404B is removed from the master 401 by use of the delamination roller 408B. This process can be repeated after the imprint sledge 402 and master 401 are brought back to the initial position. Prior to a new cycle the robot 412 can reposition the master 401.

## Claims

1. Flexible stamp (102) for use in an imprinting process comprising:
o a carrier (102A), the carrier (102A) comprising a first surface and
o at least two spots of a flexible material (201, 301, 303) which spots
▪ are separate from each other and adhered to the first surface of the carrier (102A) and
▪ have a surface which
• is parallel to the front surface of the carrier (102A) and
• is textured by an imprinting pattern (202, 302),
**characterized in that**
• the surface is above the first surface of the carrier (102A), and
• the imprinting pattern (202, 302) has a size which is smaller than the size of the spot.

2. Flexible stamp (102) according to claim 1, wherein the flexible material is a polymeric material.

3. Flexible stamp (102) according to any one or more of the previous claims, wherein the surface of the spots is higher above the first surface of the carrier (102A) than the depth of the deepest depression of the imprinting pattern (202, 302).

4. Flexible stamp (102) according to any one or more of the previous claims, wherein all spots have the same texture.

5. Flexible stamp (102) according to any one or more of the previous claims, wherein the spots are reversibly adhered to the carrier (102A).

6. Flexible stamp (102) according to any one or more of the previous claims, wherein the polymeric material of the spots has a surface free energy of 50 mN/m preferably 35 mN/m even more preferred 30 mN/m or lower.

7. Flexible stamp (102) according to any one or more of the previous claims, wherein the flexible polymeric material is selected from a group consisting of epoxides, thiols, polyvinyl resins, acrylates, methacrylates, polyethers, fluorinated acrylates, fluorinated methacrylates, fluorinated polyethers, siloxanes, siloxane-acrylates, or blends thereof.

8. Flexible stamp (102) according to any one or more of the previous claims, wherein at least one spot comprises several layers.

9. Flexible stamp (102) according to claim 8, wherein at least one layer is a thin glass sheet, a thin metal sheet, or a thin layer of polymeric material, more specific a thin layer of polycarbonate, or polyethylene terephthalate.

10. Flexible stamp (102) according to any one or more of the previous claims, wherein the flexible stamp comprises channels or other areas of empty space between the spots on the carrier (102A).

11. Flexible stamp (102) according to any one or more of the previous claims, wherein the areas between the spots are filled with additional material.

12. Flexible stamp (102) according to claim 11, wherein the additional material is an anti-stick material or a hard-coat resin.

13. A process for making a flexible stamp (102) according to any one or more of claims 1 to 12, comprising the steps of
a. providing at least one master, comprising a textured area,
b. providing a carrier (102A),
c. providing a curable resin to the master or to the carrier (102A),
d. bringing the carrier (102A) and the master in contact with the resin in between,
e. optionally exerting pressure to the carrier (102A) in such a way that the resin fills up the textured area and forms a layer covering the textured area,
f. curing the resin while the resin is in contact with both the master and the carrier (102A),
g. separating the carrier (102A) with the cured resin from the master,
h. moving the at least one master relative to the contact plane and in a plane parallel to the plane of the carrier (102A),
o with the steps d) to g) being carried out at least two times, such that a flexible stamp (102) is obtained comprising a carrier (102A) comprising a first surface and at least two spots of a flexible material which spots are separate from each other and adhered to the first surface of the carrier (102A) and have a surface which
• is parallel to the front surface of the carrier (102A) and
• is textured by an imprinting pattern (202, 302),
**characterized in that**
• the surface is above the first surface of the carrier (102A), and
• the imprinting pattern (202, 302) has a size which is smaller than the size of the spot.

## Patentansprüche

1. Flexibler Stempel (102) zur Verwendung in einem Prägeprozess, umfassend:
∘ einen Träger (102A), wobei der Träger (102A) eine erste Oberfläche und
∘ mindestens zwei Punkte aus einem flexiblen Material (201, 301, 303) umfasst, wobei die Punkte
▪ voneinander getrennt sind und an der ersten Oberfläche des Trägers (102A) haften und
▪ eine Oberfläche aufweisen, die
• parallel zu der Vorderseite des Trägers (102A) ist und
• durch ein Prägemuster (202, 302) texturiert ist, **dadurch gekennzeichnet, dass**
- die Oberfläche über der ersten Oberfläche des Trägers (102A) liegt und
- das Prägemuster (202, 302) eine Größe aufweist, die kleiner ist als die Größe des Punktes.

2. Flexibler Stempel (102) nach Anspruch 1, wobei das flexible Material ein Polymermaterial ist.

3. Flexibler Stempel (102) nach einem oder mehreren der vorstehenden Ansprüche, wobei die Oberfläche der Punkte über der ersten Oberfläche des Trägers (102A) höher liegt als die Tiefe der tiefsten Vertiefung des Prägemusters (202, 302).

4. Flexibler Stempel (102) nach einem oder mehreren der vorstehenden Ansprüche, wobei alle Punkte die gleiche Textur aufweisen.

5. Flexibler Stempel (102) nach einem oder mehreren der vorstehenden Ansprüche, wobei die Punkte reversibel auf den Träger (102A) haften.

6. Flexibler Stempel (102) nach einem oder mehreren der vorstehenden Ansprüche, wobei das Polymermaterial der Punkte eine freie Oberflächenenergie von 50 mN/m, vorzugsweise 35 mN/m, noch bevorzugter 30 mN/m oder weniger aufweist.

7. Flexibler Stempel (102) nach einem oder mehreren der vorstehenden Ansprüche, wobei das flexible Polymermaterial ausgewählt ist aus einer Gruppe bestehend aus Epoxiden, Thiolen, Polyvinylharzen, Acrylaten, Methacrylaten, Polyethern, fluorierten Acrylaten, fluorierten Methacrylaten, fluorierten Polyethern, Siloxanen, Siloxanacrylaten oder Mischungen davon.

8. Flexibler Stempel (102) nach einem oder mehreren der vorstehenden Ansprüche, wobei mindestens ein Punkt mehrere Schichten umfasst.

9. Flexibler Stempel (102) nach Anspruch 8, wobei mindestens eine Schicht eine dünne Glasplatte, eine dünne Metallplatte oder eine dünne Schicht aus Polymermaterial ist, genauer gesagt eine dünne Schicht aus Polycarbonat oder Polyethylenterephthalat.

10. Flexibler Stempel (102) nach einem oder mehreren der vorstehenden Ansprüche, wobei der flexible Stempel Kanäle oder andere Bereiche mit Leerraum zwischen den Punkten auf dem Träger (102A) umfasst.

11. Flexibler Stempel (102) nach einem oder mehreren der vorstehenden Ansprüche, wobei die Bereiche zwischen den Punkten mit zusätzlichem Material gefüllt sind.

12. Flexibler Stempel (102) nach Anspruch 11, wobei das zusätzliche Material ein Antihaftmaterial oder ein Hartbeschichtungsharz ist.

13. Verfahren zur Herstellung eines flexiblen Stempels (102) nach einem oder mehreren der Ansprüche 1 bis 12, umfassend die folgenden Schritte
a. Bereitstellen mindestens einer Vorlage, die einen texturierten Bereich umfasst,
b. Bereitstellen eines Trägers (102A),
c. Bereitstellen eines härtbaren Harzes für die Vorlage oder den Träger (102A),
d. Inkontaktbringen des Trägers (102A) und der Vorlage mit dem dazwischen befindlichen Harz,
e. gegebenenfalls Ausüben von Druck auf den Träger (102A) in einer solchen Weise, dass das Harz den texturierten Bereich ausfüllt und eine Schicht bildet, die den texturierten Bereich bedeckt,
f. Aushärten des Harzes, während das Harz sowohl mit der Vorlage als auch mit dem Träger in Kontakt ist,
g. Trennen des Trägers (102A) mit dem ausgehärteten Harz von der Vorlage,
h. Bewegen der mindestens einen Vorlage relativ zu der Kontaktfläche und in einer Ebene parallel zu der Ebene des Trägers (102A),
∘ wobei die Schritte d) bis g) mindestens zweimal durchgeführt werden, sodass ein flexibler Stempel (102) erhalten wird, der einen Träger (102A) mit einer ersten Oberfläche und mindestens zwei Punkte aus einem flexiblen Material umfasst, wobei die Punkte voneinander getrennt sind und an der ersten Oberfläche des Trägers (102A) haften und eine Oberfläche aufweisen, die
• parallel zu der Vorderseite des Trägers (102A) ist und
• durch ein Prägemuster (202, 302) texturiert ist, **dadurch gekennzeichnet, dass**
- die Oberfläche über der ersten Oberfläche des Trägers (102A) liegt und
- das Prägemuster (202, 302) eine Größe aufweist, die kleiner ist als die Größe des Punktes.

## Revendications

1. Tampon souple (102) pour utilisation dans un processus d'impression comprenant :
∘ un support (102A), le support (102A) comprenant une première surface et
∘ au moins deux points d'une matière souple (201, 301, 303), lesquels points
▪ sont séparés l'un de l'autre et adhèrent à la première surface du support (102A) et
▪ présentent une surface qui
• est parallèle à la surface avant du support (102A) et
• est texturée par un motif d'impression (202, 302), **caractérisé en ce que**
- la surface est au-dessus de la première surface du support (102A), et
- le motif d'impression (202, 302) présente une taille qui est inférieure à la taille du point.

2. Tampon souple (102) selon la revendication 1, dans lequel la matière souple est une matière polymère.

3. Tampon souple (102) selon une ou plusieurs quelconques des revendications précédentes, dans lequel la surface des points est plus élevée au-dessus de la première surface du support (102A) que la profondeur du creux le plus profond du motif d'impression (202, 302).

4. Tampon souple (102) selon une ou plusieurs quelconques des revendications précédentes, dans lequel tous les points présentent la même texture.

5. Tampon souple (102) selon une ou plusieurs quelconques des revendications précédentes, dans lequel les points sont collés de manière réversible au support (102A).

6. Tampon souple (102) selon une ou plusieurs quelconques des revendications précédentes, dans lequel la matière polymère des points présente une énergie libre de surface de 50 mN/m, de préférence 35 mN/m, et mieux encore inférieure ou égale à 30 mN/m.

7. Tampon souple (102) selon une ou plusieurs quelconques des revendications précédentes, dans lequel la matière polymère souple est sélectionnée dans un groupe consistant en des époxydes, des thiols, des résines polyvinyliques, des acrylates, des méthacrylates, des polyéthers, des acrylates fluorés, des méthacrylates fluorés, des polyéthers fluorés, des siloxanes, des siloxane-acrylates, ou des mélanges de ceux-ci.

8. Tampon souple (102) selon une ou plusieurs quelconques des revendications précédentes, dans lequel au moins un point comprend plusieurs couches.

9. Tampon souple (102) selon la revendication 8, dans lequel au moins une couche est une fine feuille de verre, une fine feuille de métal ou une fine couche de matière polymère, plus précisément une fine couche de polycarbonate ou de polyéthylène téréphtalate.

10. Tampon souple (102) selon une ou plusieurs quelconques des revendications précédentes, dans lequel le tampon souple comprend des canaux ou d'autres zones d'espace vide entre les points sur le support (102A).

11. Tampon souple (102) selon une ou plusieurs quelconques des revendications précédentes, dans lequel les zones entre les points sont remplies d'une matière supplémentaire.

12. Tampon souple (102) selon la revendication 11, dans lequel la matière supplémentaire est une matière antiadhérente ou une résine à revêtement dur.

13. Processus de fabrication d'un tampon souple (102) selon une ou plusieurs quelconques des revendications 1 à 12, comprenant les étapes suivantes
a. la fourniture d'au moins un original, comprenant une zone texturée,
b. la fourniture d'un support (102A),
c. la fourniture d'une résine durcissable sur l'original ou sur le support (102A),
d. la mise en contact du support (102A) et de l'original, la résine étant située entre les deux,
e. l'application éventuelle d'une pression sur le support (102A) afin que la résine remplisse la zone texturée et forme une couche recouvrant la zone texturée,
f. le durcissement de la résine en même temps que la résine est en contact à la fois avec l'original et le support (102A),
g. la séparation du support (102A), avec la résine durcie, de l'original,
h. le déplacement de l'au moins un original par rapport au plan de contact et dans un plan parallèle au plan du support (102A),
∘ les étapes d) à g) étant effectuées au moins deux fois, de sorte qu'un tampon souple (102) soit obtenu comprenant un support (102A) comprenant une première surface et au moins deux points d'une matière souple, lesquels points sont séparés l'un de l'autre et collés à la première surface du support (102A) et présentent une surface qui
• est parallèle à la surface avant du support (102A) et
• est texturée par un motif d'impression (202, 302), **caractérisé en ce que**
- la surface est au-dessus de la première surface du support (102A), et
- le motif d'impression (202, 302) présente une taille qui est inférieure à la taille du point.
